(19) Europäisches Patentamt
European Patent Office
Office européen des brevets

(11) Numéro de publication: 0 241 383 B1

(12) FASCICULE DE BREVET EUROPEEN

(45) Date de publication du fascicule du brevet: **23.01.91**

(51) Int. Cl.$^5$: **H 03 H 11/12**, H 03 H 1/02

(21) Numéro de dépôt: **87400820.4**

(22) Date de dépôt: **10.04.87**

# (54) Cellule de filtrage passe-bas pour circuit intégré.

(30) Priorité: **11.04.86 FR 8605237**

(43) Date de publication de la demande:
**14.10.87 Bulletin 87/42**

(45) Mention de la délivrance du brevet:
**23.01.91 Bulletin 91/04**

(84) Etats contractants désignés:
**AT DE ES FR GB IT NL SE**

(56) Documents cités:
**EP-A-0 165 766**
**US-A-3 466 538**
**US-A-3 492 606**

**W. HEINLEIN et al.: "Active filters for integrated circuits", 1974, pages 336-340, Springer-Verlag, New York, US;**

**IEEE JOURNAL OF SOLID-STATE CIRCUITS, vol. SC-17, no. 6, décembre 1982, pages 1076-1080, IEEE, New York, US; B.K. AHUJA: "Implementation of active distributed RC anti-aliasing/smoothing filters"**

(73) Titulaire: **THOMSON SEMICONDUCTEURS**
**101, bld Murat**
**F-75016 - Paris (FR)**

(72) Inventeur: **Ramet, Serge**
**THOMSON - CSF SCPI 19, avenue de Messine**
**F-75008 Paris (FR)**

(74) Mandataire: **Guérin, Michel et al**
**THOMSON-CSF SCPI**
**F-92045 PARIS LA DEFENSE CEDEX 67 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).



Courier Press, Leamington Spa, England.

## Description

L'invention concerne une cellule de filtre passe-bas spécialement destinée à être réalisée sous forme de circuit intégré.

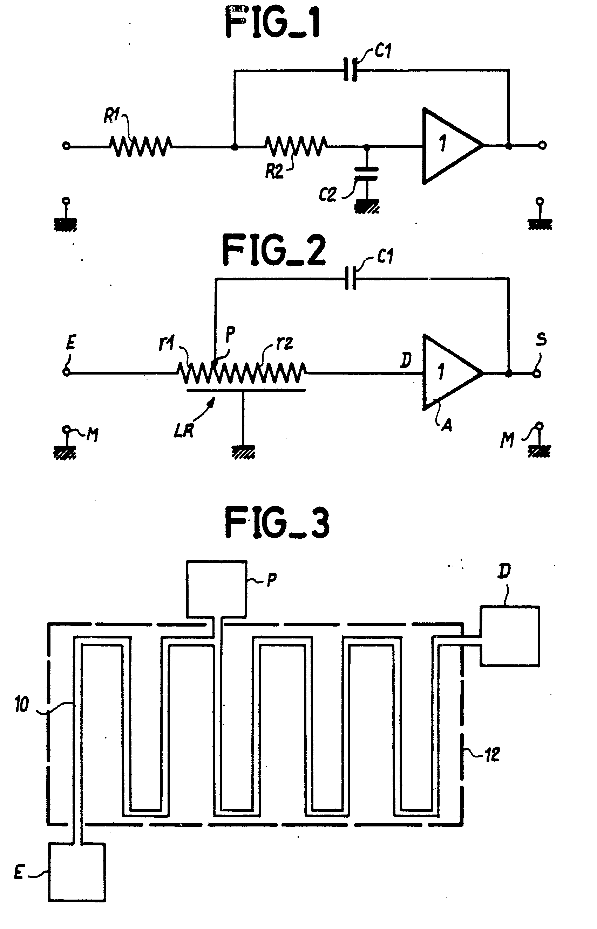

Une cellule de filtre passe-bas du deuxième ordre très classiquement utilisée est la cellule dite "de Sallen and Key" représentée à la figure 1. Elle comprend deux résistances R1, R2, deux capacités C1, C2 et un amplificateur à gain unitaire, à grande impédance d'entrée et à faible impédance de sortie.

Les valeurs des résistances et des capacités règlent la forme de la courbe de réponse en fréquence de cette cellule. Une forme de courbe de réponse que l'on souhaite souvent obtenir est celle qui correspond à une fonction de transfert dite de Butterworth d'ordre 2, c'est-à-dire une fonction de transfert avec coefficient d'amortissement égal à l'inverse de la racine carrée de 2. Cette fonction de transfert particulière correspond en effet à une courbe de réponse la plus plate possible dans la bande passante (pas de surtension au voisinage de la fréquence de coupure).

On peut montrer que pour la cellule de Sallen and Key de la figure 1, cette courbe de réponse particulière est obtenue à condition que la capacité C1 ait une valeur double de la capacité C2 et que les résistances R1 et R2 aient même valeur:

$$C1=2C2 \text{ et } R1=R2$$

Si les résistances R1 et R2 sont réalisées par une diffusion d'impuretés de type P à faible concentration dans un substrat de silicium monocristallin, on aboutit à un faible encombrement de la cellule, mais au prix de l'apparition d'une certaine distorsion de signal due à la non-linéarité de ces résistances.

Si les résistances R1 et R2 sont réalisées en silicium polycristallin, la non-linéarité et la distorsion disparaissent, mais l'encombrement est considérablement plus important, aussi bien en ce qui concerne les résistances, qu'en ce qui concerne les capacités: dans un exemple, on a pu constater que pour obtenir la même courbe de réponse il fallait dans un cas (silicium polycristallin) des résistances 40 fois plus encombrantes et des capacités 6 fois plus encombrantes que dans l'autre cas (diffusion $P^-$).

On a proposé par ailleurs des schémas de filtres à constantes réparties destinés à remplir la même fonction globale de filtrage passe-bas mais en utilisant des éléments de circuit à résistances et capacités réparties à la place du circuit de la figure 1 qui possède des résistances et des capacités bien distinctes les unes des autres. Ces schémas à constantes réparties ont été proposés dans le but d'améliorer l'atténuation au delà de la fréquence de coupure. En effet leur atténuation peut être exponentielle et donc meilleure que l'atténuation d'un véritable filtre du deuxième ordre tel que la cellule de Sallen et Key.

L'élément à constantes réparties peut être typiquement une ligne de silicium polycristallin (présentant une certaine résistance) formée par gravure d'une couche résistive de silicium polycristallin, isolée par une mince couche diélectrique d'une couche conductrice de silicium polycristallin ou de toute autre couche conductrice constituant une armature de capacité dont l'autre armature est la ligne résistive. Voir par exemple l'article de B. K. Ahuja dans IEEE Journal of Solid-State Circuits, vol. SC-17, no. 6, décembre 1982, pages 1076—1080.

Mais les cellules de filtrage passe-bas à constantes réparties proposées jusqu'à maintenant ne sont pas très bonnes en ce qui concerne l'encombrement global de la cellule pour une forme de courbe de réponse donnée (en particulier pour une fréquence de coupure donnée).

L'invention propose un schéma de cellule de filtrage passe-bas à constantes réparties qui est amélioré du point de vue de l'encombrement (pour une technologie donnée) par rapport aux cellules connues.

La cellule selon l'invention comprend un amplificateur à gain unitaire, à grande impédance d'entrée et faible impédance de sortie, une ligne résistive ayant une entrée, une sortie et une prise intermédiaire, cette ligne étant disposée au-dessus d'une plaque conductrice de manière à présenter une capacité répartie par rapport à cette plaque, l'entrée de la ligne constituant l'entrée de la cellule de filtrage, la sortie de la ligne étant reliée à l'entrée de l'amplificateur, la sortie de l'amplificateur constituant la sortie de la cellule et étant reliée par une capacité à la prise intermédiaire, la fraction de résistance de la ligne entre l'entrée de la ligne et la prise intermédiaire par rapport à la résistance globale de la ligne étant comprise entre 0,2 et 0,49, de préférence entre 0,27 et 0,4 et si possible proche de 1/3.

D'autres caractéristiques et avantages de l'invention apparaîtront à la lecture de la description détaillée qui suit et qui est faite en référence aux dessins annexés dans lesquels:

—la figure 1 déjà décrite représente une cellule de filtrage de Sallen et Key,

—la figure 2 représente la cellule selon l'invention,

—la figure 3 représente une manière de réaliser la ligne résistive à constante répartie nécessaire dans la cellule selon l'invention.

La cellule de la figure 2 comprend un amplificateur A à gain unitaire, à grande impédance d'entrée et faible impédance de sortie, une capacité C1 et une ligne résistive à constantes réparties LR.

L'entrée de la cullule est désignée par E, la sortie par S, et les signaux d'entrée et de sortie sont des tensions par rapport à une masse M.

La ligne résistive à constantes réparties comprend:

—une ligne résistive proprement dite,

—une armature conductrice reliée à la masse M, la ligne résistive étant isolée de l'armature par un diélectrique mince de sorte qu'une capacité existe entre la ligne résistive et l'armature, cette capacité étant répartie sur toute la longueur de la ligne,

—une prise intermédiaire P permettant d'accéder à la ligne résistive en un point situé entre l'entrée et la sortie de la ligne.

L'entrée de la ligne résistive LR est reliée à l'entrée E de la cellule; la sortie de la ligne résistive LR est reliée a l'entrée D de l'amplificateur A. La sortie de cellule est constituée par la sortie de l'amplificateur A.

La capacité C1 est reliée entre la sortie de l'amplificateur et la prise intermédiaire P.

Selon l'invention, pour minimiser l'encombrement de la cellule (pour une technologie donnée) tout en ayant une courbe de réponse la plus plate possible (notamment sans surtension au voisinage de la fréquence de coupure), la présente invention prévoit que la prise intermédiaire P n'est pas située au milieu de la ligne résistive comme une comparaison avec la cellule de Sallen and Key pourrait le suggérer, mais est située plus près de l'entrée de la cellule à une position telle que le rapport r1/(r1+r2) entre la résistance r1 de la portion de ligne située entre les points E et P et la résistance totale (r1+r2) de la ligne entre les points E et D soit compris entre 0,2 et 0,49 ou mieux entre 0,27 et 0,4 et de préférence le plus proche possible de 1/3.

La figure 3 indique schématiquement un mode de réalisation de la ligne résistive à constantes réparties LR.

La ligne est constituée par un ruban 10 de silicium polycristallin résistif d'une couche supérieure, ce ruban passant au-dessus d'une couche conductrice 12 pouvant être constituée par une couche inférieure de silicium polycristallin. La couche inférieure est présente partout au-dessous de la ligne résistive. Elle est de préférence constituée sous forme d'un rectangle de silicium polycristalline de largeur très supérieure à celle du ruban 10 (à moins que la couche inférieure 12 n'ait une résistivité très faible qui permettrait de se contenter d'avoir une couche inférieure 12 en forme de ruban s'étendant sous le ruban 10).

La couche inférieure et la couche supérieure sont séparées par une couche diélectrique mince, par example un oxyde de silicium. Les bornes extrêmes de la ligne ainsi que la prise intermédiaire sont constituées par des plots élargis de la couche supérieure de silicium polycristallin, ces plots pouvant être reliés à des contacts métalliques par lesquels ils sont connectés à d'autres éléments de circuit et plus particulièrement à l'entrée E de la cellule, à l'entrée D de l'amplificateur et à la capacité C1.

On peut montrer que le gain en encombrement de la cellule selon l'invention peut être de 15 à 20% par rapport à une cellule de Sallen and Key utilisant des résistances en silicium polycrystallin; ce gain est très important pour des circuits intégrés.

## Revendications

1. Cellule de filtrage passe-bas comprenant un amplificateur (A) à gain unitaire, à grande impédance d'entrée et à faible impédance de sortie, une ligne résistive à capacité répartie (LR) et une capacité (C1), caractérisée en ce que la ligne résistive comprend une entrée (E) constituant une entrée pour la cellule, une sortie (D) reliée à l'entrée de l'amplificateur, et une prise intermédiaire (P) reliée par l'intermédiaire de la capacité (C1) à la sortie de l'amplificateur, la ligne résitive étant située au-dessus d'une plaque conductrice dont elle est isolée par un diélectrique mince pour constituer entre la ligne et la plaque une capacité répartie le long de la ligne, la prise intermédiaire (P) étant située à une position telle que la fraction r1/(r1+r2) de la résistance (r1) de la ligne entre l'entrée de la cellule et la prise intermédiaire par rapport à la résistance globale (r1+r2) de la ligne est comprise entre 0,2 et 0,49.

2. Cellule de filtrage passe-bas selon la revendication 1, caractérisée en ce que ladite fraction est très proche de 1/3.

## Patentansprüche

1. Tiefpaß-Filterzelle mit einem Verstärker (A) mit Einheitsverstärkung, hoher Eingangsimpedanz und niedriger Ausgangsimpedanz, einem resistiven Leitungsteil (LR) mit verteilter Kapazität und einem Kondensator (C1), dadurch gekennzeichnet, daß der resistive Leitungsteil einen Eingang (E) aufweist, welcher den Eingang der Zelle bildet, einen mit dem Eingang des Verstärkers verbundenen Ausgang (D) und einen Zwischenabgriff (P), welcher über den Kondensator (C1) mit dem Ausgang des Verstärkers verbunden ist, wobei der resistive Leitungsteil über einer leitenden Platte angeordnet ist, von der er mittels eines dünnen Dielektrikums isoliert ist, um zwischen dem Leitungsteil und der Platte eine längs dem Leitungsteil verteilte Kapazität zu bilden, wobei der Zwischenabgriff (P) in einer solchen Position angeordnet ist, daß das Verhältnis r1/(r1+r2) des Widerstandes (r1) des Leitungsstückes zwischen dem Eingang der Zelle und dem Zwischenabgriff bezüglich des Gesamtwiderstandes (r1+r2) des Leitungsteiles zwischen 0,2 und 0,49 beträgt.

2. Tiefpaß-Filterzelle nach Anspruch 1, dadurch gekennzeichnet, daß das genannte Verhältnis sehr nahe dem Wert 1/3 liegt.

## Claims

1. A low-pass filtering cell comprising a unit gain amplifier (A) with high input impedance and low output impedance, a resistive line (LR) with distributed capacitance and a capacitor (C1) characterized in this that said resistive line has an input (E) which constitutes an input for the cell, an output (D) connected to the input of the amplifier, and an intermediate tap (P) connected by means of the capacitor (C1) to the output of the amplifier, said resistive line being placed above a conducting plate from which it is insulated by a thin dielectric to constitute, between the line and the plate, a capacitance distributed along the line, the intermediate tape (P) being located at a position such that the fraction r1/(r1+r2) of the resistance (r1) of

the line between the input of the cell and the intermediate tap with respect to the overall resistance (r1+r2) of the line ranges from 0.2 to 0.49.

2. A low-pass filtering cell according to claim 1 characterized in this that said fraction is very close to 1/3.

FIG_1

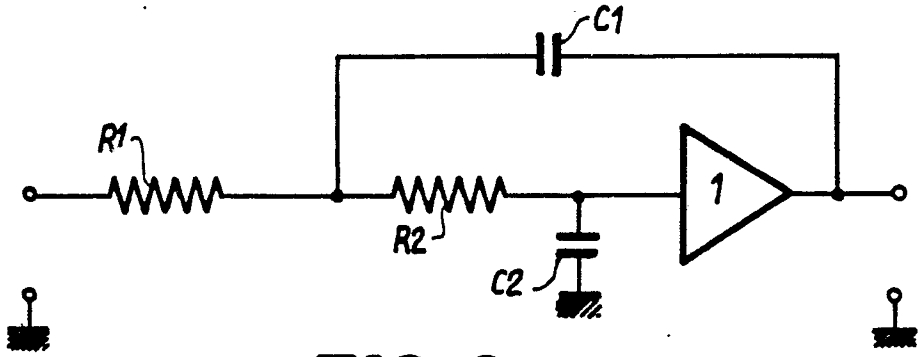


FIG_2

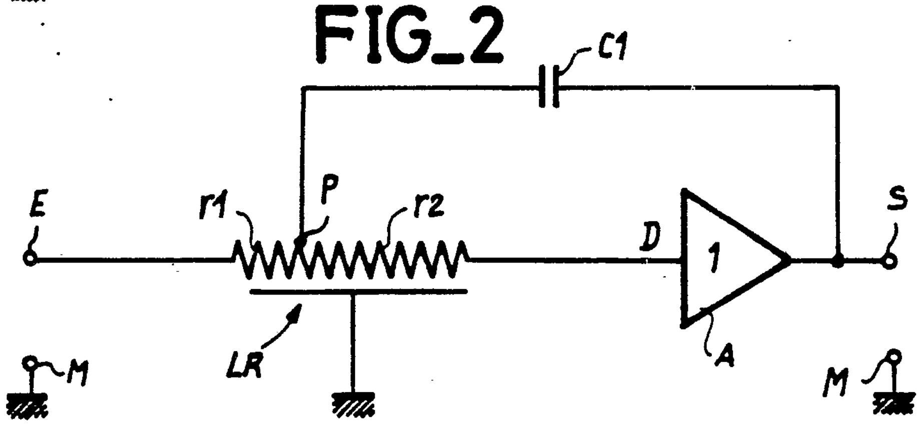


FIG_3